# EUROPÄISCHE PATENTANMELDUNG

(11) **EP 0 765 025 A2**
(43) Veröffentlichungstag der Anmeldung: **26.03.1997**
(21) Anmeldenummer: 96113011.9
(22) Anmeldetag: 13.08.1996
(51) Int. Cl.: H02M 3/335

(54) **Anlaufschaltung und Halbleiterkörper für eine solche Anlaufschaltung**

(30) Priorität: 21.09.1995 DE 19535120
(71) Anmelder: SIEMENS AKTIENGESELLSCHAFT, 80333 München (DE)
(72) Erfinder: Tihanyi, Jenö, Dr.Ing., 85551 Kirchheim (DE)

(57) **Zusammenfassung**

Die Anlaufschaltung weist drei Klemmen (1, 2, 3) auf. Zwischen die erste Klemme (1) und die dritte Klemme (3) ist ein Depletion-MOS-FET (4) mit seiner Laststrecke geschaltet. Eine Zenerdiode (5) liegt zwischen der zweiten Klemme (2) und einem Gateanschluß (G) des Depletion-MOS-FET (4). Des weiteren ist zwischen die dritte Klemme (3) und den Gateanschluß (G) des Depletion-MOS-FET (4) ein Widerstand (6), vorzugsweise ein MOS-FET, geschaltet. Die Anlaufschaltung dient zur anfänglichen Stromversorgung einer Schaltungsanordnung, insbesondere eines Schaltnetzteiles, und ist mit ihrer ersten und zweiten Klemme (1) (2) an zwei Anschlüsse einer Eingangsspannung und mit ihrer zweiten und dritten Klemme (2) (3) an die Schaltungsanordnung anschließbar. Nach einem erfolgten Anlaufen der Schaltungsanordnung schaltet der Depletion-MOS-FET aus und damit die Anlaufschaltung ab, so daß die Verlustleistung der gesamten Anordnung erheblich reduziert wird.

## Beschreibung

Die Erfindung betrifft eine Anlaufschaltung für eine Schaltungsanordnung mit drei Klemmen, von denen eine erste Klemme und eine zweite Klemme mit zwei Anschlüssen einer Eingangsspannung und die zweite Klemme und eine dritte Klemme mit der Schaltungsordnung verbindbar sind, sowie einen Halbleiterkörper für eine solche Anlaufschaltung.

Solche Anlaufschaltungen sind allgemein bekannt und werden insbesondere zur anfänglichen Spannungsversorgung von Steuereinrichtungen in Schaltnetzteilen vorgesehen. Schaltnetzteile weisen regelmäßig ein Halbleiterschaltelement zum getakteten Anlegen einer gewöhnlich aus einer Netzwechselspannung gewonnenen Spannung an eine Primärwicklung eines Übertragers auf. Das Halbleiterschaltelement wird dabei von der Steuereinrichtung pulsbreitenmoduliert angesteuert. Während der Anlaufphase des Schaltnetztteiles und damit unmittelbar nach dem Einschalten, wird die Speisespannung von der hierfür extra vorzusehenden Anlaufschaltung bereitgestellt. Nach dem erfolgten Anlaufen des Schaltnetzteiles wird die Speisespannung von einer Regelungswicklung des im Schaltnetzteil vorgesehenen Übertragers mit nachgeschaltetem Gleichrichter erzeugt.

Aus EP-A-0 494 327 ist eine Anlaufschaltung bekannt, die drei Klemmen aufweist und zwischen den Ausgang eines Brückengleichrichters und einer Steuereinrichtung, hier dem integrierten Schaltkreis TDA 4605 von Siemens, geschaltet ist. Die Anlaufschaltung besteht im wesentlichen aus einem RC-Glied, bei welchem der Widerstand zwischen den positiven Ausgang des Brückengleichrichters und der Speisespannungsklemme der Steuereinrichtung geschaltet ist. Der Kondensator ist zwischen Bezugspotential und die erwähnte Speisespannungsklemme der Steuereinrichtung geschaltet. Der ohmsche Widerstand der Anlaufschaltung ist so dimensioniert, daß bei einer vorgegebenen minimalen Netzwechselspannung ein Strom von mindestens 1 mAmpere zum Laden des Kondensators verbleibt. Nachdem die Steuereinrichtung durch die Anlaufschaltung mit Spannung versorgt wird, beginnt das Steuer-IC zu arbeiten, wodurch das Halbleiterschaltelement des Schaltnetzteiles angesteuert wird. Am Schaltnetzteil sind sekundärseitig Ausgangsspannungen abgreifbar, wobei diese Ausgangsspannungen als Hilfsspannung für die Spannungsversorgung der Steuereinrichtung verwendet wird.

Problematisch bei solchen bekannten Anlaufschaltungen ist, daß die Anlaufschaltung nach einem erfolgreichen Anlaufen des Schaltnetzteiles für den weiteren Betrieb nicht mehr notwendig wäre, jedoch weiterhin unnötigerweise Strom verbraucht, was die Verlustleistung des Schaltnetzteiles erhöht. Es ist deshalb in der bekannten Veröffentlichung vorgeschlagen worden, anstelle des Widerstandes einen Kaltleiter zu verwenden, dessen Widerstandswert sich mit zunehmender Erwärmung so stark erhöht, daß nahezu kein Stromfluß durch diesen Kaltleiter zur Steuereinrichtung nach einem erfolgten Anlaufen mehr möglich ist.

Der Erfindung liegt die Aufgabe zugrunde, eine Anlaufschaltung anzugeben, bei der die entstehende Verlustleistung auf andere Weise erheblich reduziert wird. Des weiteren soll mit der Erfindung ein einfach herzustellender Halbleiterkörper für eine solche Anlaufschaltung angegeben werden.

Diese Aufgabe wird für die eingangs genannte Anlaufschaltung durch folgende weitere Merkmale gelöst:
a) Zwischen die erste Klemme und die dritte Klemme ist ein Depletion-MOS-FET mit seiner Laststrecke geschaltet,
b) zwischen die zweite Klemme und einem Gateanschluß des Depletion-MOS-FET ist eine Zenerdiode geschaltet,
c) zwischen die dritte Klemme und den Gateanschluß des Depletion-MOS-FET ist ein Widerstand geschaltet.

Die Erfindung beruht im wesentlichen darauf, eine "schaltbare" Anlaufschaltung vorzusehen. Sobald die Anlaufschaltung im Betrieb der Schaltungsanordnung nicht mehr benötigt wird, wird diese abgeschaltet. Hierdurch kann die Verlustleistung der mit der Anlaufschaltung verbundenen Schaltungsanordnung erheblich reduziert werden.

Weiterbildungen der Anlaufschaltung sind in den auf den Anspruch 1 zurückbezogenen Ansprüchen angegeben.

Einen Halbleiterkörper für eine Anlaufschaltung weist einen n⁻-dotierten Grundkörper auf, an dessen unteren Hauptfläche eine n⁺-dotierte Zone anschließt. An der oberen Hauptfläche des n⁻-dotierten Grundkörpers sind n⁺-dotierte Wannen enthaltende p-dotierte Zonen zur Bildung eines vertikalen Depletion-MOS-FET, in einem zweiten Bereich ein lateraler Widerstand und in einem dritten Bereich eine n⁺-dotierte Wanne einhaltende Zone zur Bildung einer Zenerdiode eingebettet.

Ein solcher Halbleiterkörper braucht lediglich mit drei von einem Gehäuse herausgeführten Klemmen versehen werden. Diese sind im Inneren des Halbleiterkörpers entsprechend der zu realisierenden Schaltungsanordnung der Anlaufschaltung verschaltet. Damit steht dem Anwender durch einen solchen Halbleiterkörper eine integrierte Schaltungsanordnung mit drei Anschlüssen zur Verfügung, die in einfacher Weise als Anlaufschaltung in Schaltungsanordnungen, z. B. in Schaltnetzteilen eingesetzt werden kann.

Die Erfindung wird nachfolgend im Zusammenhang mit drei Figuren näher erläutert. Es zeigen:
- Figur 1: Ein Ausführungsbeispiel einer Anlaufschaltung nach der Erfindung,
- Figur 2: ein Ausführungsbeispiel eines Halbleiterkörpers für eine Anlaufschaltung nach Figur 1 und
- Figur 3: ein Blockschaltbild eines Schaltnetzteiles mit einer Anlaufschaltung gemäß Figur 1 bzw. Figur 2.

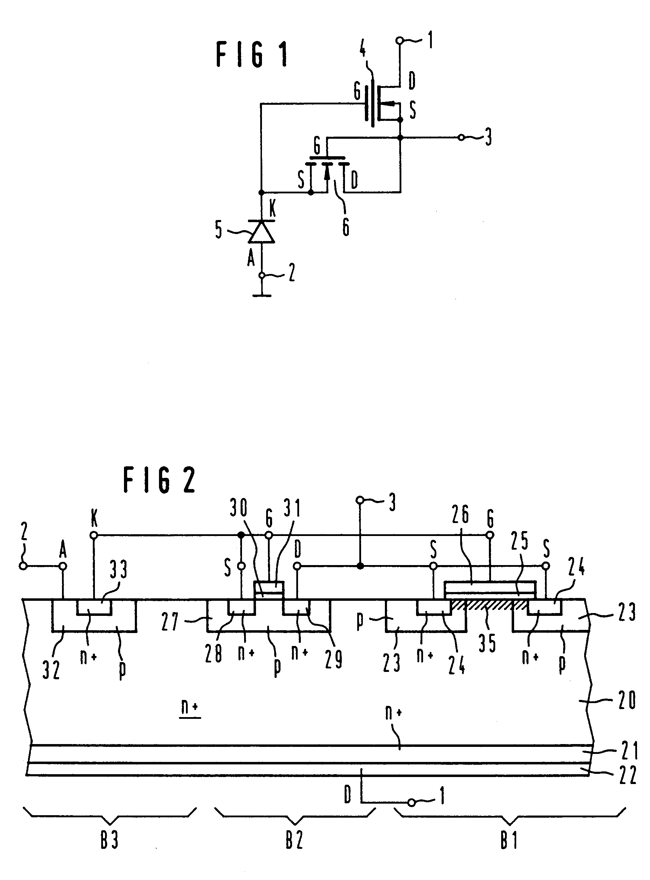

In Figur 1 ist ein Ausführungsbeispiel einer Anlaufschaltung nach der Erfindung dargestellt. Die Anlaufschaltung weist eine erste Klemme 1, eine zweite Klemme 2, sowie eine dritte Klemme 3 auf. Die zweite Klemme 2 liegt auf Massepotential, während die erste Klemme 1 den Eingang und die dritte Klemme 3 den Ausgang der Anlaufschaltung darstellt. Demzufolge sind die Klemmen 1 und 2 an die Anschlüsse einer Eingangsspannung und die Klemmen 2 und 3 an die Anschlüsse der von der Anlaufschaltung zu versorgenden Schaltungsanordnung anzuschließen.

Zwischen der ersten Klemme 1 und der dritten Klemme 3 ist ein Depletion-MOS-FET 4 mit seiner Laststrecke geschaltet. Hierbei liegt der Drainanschluß D an der ersten Klemme 1 und der Sourceanschluß S an der dritten Klemme 3. Zwischen die zweite Klemme 2 und den Gateanschluß G des Depletion-MOS-FET 4 ist eine Zenerdiode 5 geschaltet. Der Anodenanschluß A ist mit der zweiten Klemme 2 und dessen Kathodenanschluß K mit dem Gateanschluß G des Depletion-MOS-FET 4 in Verbindung. Schließlich weist die Anlaufschaltung noch einen hochohmigen Widerstand auf, der zwischen den Kathodenanschluß K der Zenerdiode 5 und die dritte Klemme 3 geschaltet ist. Im vorliegenden Ausführungsbeispiel ist dieser hochohmige Widerstand als MOS-FET 6 realisiert. Der MOS-FET 6 ist ein Enhancement-MOS-FET, dessen Drainanschluß D und Gateanschluß G gemeinsam an die dritte Klemme 3 und dessen Sourceanschluß S an den Kathodenanschluß K der Zenerdiode 5 geschaltet sind. Die Zenerdiode 5 weist vorzugsweise eine Zenerspannung von etwa 6 - 10 Volt auf. Der Depletion-MOS-FET 4 hat, damit die Anlaufschaltung generell einsetzbar ist, vorzugsweise eine Durchbruchsspannung von etwa 800 - 1000 Volt. Um zu gewährleisten, daß keine oder möglichst kein Strom von der zweiten Klemme 2 zur dritten Klemme 3 fließt, wenn die Zenerspannung der Zenerdiode 5 kleiner als die zwischen der zweiten Klemme 2 und der dritten Klemme 3 liegende Spannung ist, weist der MOS-FET 6 eine verhältnismäßig hohe Einsatzspannung auf, die beispielsweise zwischen etwa 3 und 10 Volt liegen kann.

Die Funktionsweise der in Figur 1 dargestellten Schaltungsanordnung ist folgende.

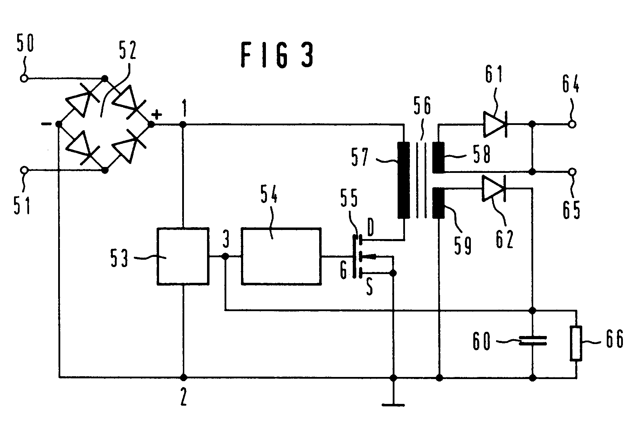

Zunächst wird davon ausgegangen, daß sich sowohl die Anlaufschaltung, als auch die zwischen die zweite Klemme 2 und die dritte Klemme 3 geschaltete und von der Anlaufschaltung zu versorgende Schaltungsanordnung in Ruhezustand befindet. An den Klemmen 1, 2 und 3 liegt keine Spannung. Anschließend wird zwischen die erste Klemme 1 und die zweite Klemme 2 eine, beispielsweise von einem Brückengleichrichter gleichgerichtete Spannung von 200 Volt angelegt. Der Depletion-MOS-FET 4 leitet, da anfänglich das Gatepotential am Gateanschluß G gleich dem Potential am Sourceanschluß S ist. Zwischen der zweiten Klemme 2 und der dritten Klemme 3 steht annähernd die Zenerspannung, z. B. + 10 Volt an. Mit diesen + 10 Volt kann die Schaltungsanordnung, z. B. das in Figur 3 dargestellte Schaltnetzteil unmittelbar nach dem Einschaltvorgang für die Dauer der Anlaufphase, d. h. solange, bis die Schaltungsanordnung selbst für die eigene Spannungsversorgung sorgt, mit einer ausreichenden Spannung zur Betriebaufnahme versorgt werden. Sobald das Potential an der dritten Klemme 3 aufgrund der internen Stromversorgung, der in Figur 1 nicht dargestellten Schaltungsanordnung größer als die Zenerspannung der Zenerdiode 5 ist, sinkt das Potential am Gateanschluß G des Depletion-MOS-FET 4 unter dessen Sourcepotential, wodurch der Depletion-MOS-FET 4 ausschaltet. Bei der vorliegenden Anlaufschaltung ist deshalb darauf zu achten, daß die gewählte Zenerspannung unterhalb der im regulären Betrieb der nicht in Figur 1 dargestellten Schaltungsanordnung an der Klemme 3 anliegenden Spannung liegt.

In Figur 2 ist ein Ausführungsbeispiel eines Halbleiterkörpers für die in Figur 1 dargestellte Anlaufschaltung gezeigt. Der Halbleiterkörper verfügt über einen n⁺-dotierten Grundkörper 20, an dessen unteren Hauptfläche eine n⁺-dotierte Zone 21 ganzflächig anschließt. An der freien Oberfläche dieser n⁺-dotierten Zone 21 ist eine Metallschicht 22 als Drainelektrode D angeordnet. Diese Metallschicht 22 stellt die erste Klemme 1 der Anlaufschaltung dar.

Der Halbleiterkörper weist drei unterschiedliche und nebeneinanderliegende Bereiche B1, B2 und B3 auf. In den ersten Bereich B1 ist der in Figur 1 vorgestellte Depletion-MOS-FET 4, in den zweiten Bereich B2 ein lateraler Widerstand, z. B. der in Figur 1 dargestellte MOS-FET 6, und in den dritten Bereich B3 die Zenerdiode 5 integriert. Hierfür sind an der oberen Hauptfläche des n⁺-dotierten Grundkörpers 20 im ersten Bereich B1 n⁺-dotierte Wannen 24 enthaltende p-dotierte Zonen 23 eingebettet. Die n⁺-dotierten Wannen 24 sind mit einer Sourceelektrode S verbunden. Zwischen den p-dotierten Zonen 23 kann sich der Kanal des Depletion-MOS-FET 4 ausbilden, weil über diesen Bereich an der oberen Hauptfläche des n⁺-dotierten Grundkörpers 20 eine Oxidschicht 25 mit darüberliegender Metallisierung 26 bzw. Polysiliziumschicht angeordnet und eine n⁻-dotierte Zone 35 in den Halbleiterkörper an der oberen Hauptfläche eingebettet ist. Die erwähnte n⁻-dotierte Zone 35 ist in Figur 2 schraffiert gezeichnet. Die Metallisierung 26 bzw. Polysiliziumschicht ist mit einer Gateelektrode G des Depletion-MOS-FET in Verbindung.

In den zweiten Bereich B2 ist, wie in Figur 2 dargestellt, ein lateraler Widerstand in Form eines Enhancement-MOS-FET integriert. Hierfür sind an der oberen Hauptfläche des n⁻-dotierten Grundkörpers 20 eine zwei n⁺-dotierte Wannen 28, 29 enthaltende p-dotierte Zone 27 eingebettet. Zwischen den beiden n⁺-dotierten Wannen 28, 29 sitzt auf der oberen Hauptfläche des n⁻-dotierten Grundkörpers 20 eine Oxidschicht 30 mit darüberliegender Metallisierung 31 bzw. Polysiliziumschicht. Die n⁺-dotierte Wanne 28 ist mit einer Sourceelektrode S und die n⁺-dotierte Wanne 29 mit einer Drainelektrode D kontaktiert. Die Metallschicht 31 steht mit einer Gateelektrode G in Verbindung. Zur Bildung eines ohmschen Widerstandes sind die Sourceelektrode S und die Gateelektrode G in diesem zweiten Bereich B2 miteinander verbunden.

Im dritten Bereich B3 ist eine Zenerdiode dadurch realisiert, daß an der oberen Hauptfläche des n⁺-dotierten Grundkörpers 20 eine eine n⁺-dotierte Wanne 33 enthaltende p-dotierte Zone 32 eingebettet ist. Die p-dotierte Zone 32 ist von einer Anodenelektrode A und die n⁺-dotierte Wanne 33 von einer Kathodenelektrode K kontaktiert.

Zur Realisierung der in Figur 1 dargestellten Anlaufschaltung sind die einzelnen Elektroden des Halbleiterkörpers folgendermaßen miteinander elektrisch in Verbindung. Die Kathodenelektrode K der Zenerdiode im dritten Bereich B3 ist elektrisch mit der Gateelektrode G und der Sourceelektrode S des MOS-FET im zweiten Bereich B2 sowie mit der Gateelektrode G des Depletion-MOS-FET im ersten Bereich B1 verbunden. Die Drainelektrode D im zweiten Bereich B2 und die Sourceelektrode S im ersten Bereich B1 sind an die dritte Klemme 3 des Halbleiterkörpers angeschlossen. Die Anodenelektrode A im dritten Bereich B3 des Halbleiterkörpers ist dagegen mit der zweiten Klemme 2 des Halbleiterkörpers in Verbindung. Der gesamte Halbleiterkörper kann mit den erwähnten elektrischen Verbindungen in bekannter SITAC-und HV Minismart-Technologie integriert werden und beispielsweise in einem sogenannten SO23 oder ähnlichem Gehäuse montiert sein. Aus diesem Gehäuse ragen lediglich die drei Klemmen 1, 2, 3 heraus, so daß dem Anwender ein einfaches Bauelement zur Verfügung gestellt wird, das ohne weiteres als Anlaufschaltung in Schaltungsanordnungen und insbesondere in Schaltnetzteilen eingesetzt werden kann.

In Figur 3 ist das Blockschaltbild eines solchen möglichen Schaltnetzteiles dargestellt. Die Anlaufschaltung ist in Figur 3 lediglich als Block dargestellt und mit dem Bezugzeichen 53 versehen. Aus dem Block der Anlaufschaltung S3 ragen die drei bereits erläuterten Klemmen 1, 2 und 3 heraus. Das Schaltnetzteil weist zwei Klemmen 50, 51 auf, die an eine Netzwechselspannung anzuschließen sind. Diese beiden Klemmen 50, 51 sind mit Eingangsklemmen eines Brückengleichrichters 52 in Verbindung. Der positive Ausgang des Brückengleichrichters 52 ist mit der ersten Klemme 1 der Anlaufschaltung 53 und die negative Ausgangsklemme des Brückengleichrichters 52 mit der zweiten Klemme 2 der Anlaufschaltung 53 in Verbindung. Die dritte Klemme 3 der Anlaufschaltung 53 ist an eine Speisespannungsklemme einer vorzugsweise integrierten Steuereinrichtung 54 geschaltet. Ausgangsseitig ist diese Steuereinrichtung 54 mit einem Halbleiterschalter, hier mit dem Gateanschluß G eines MOS-FET 55 in Kontakt. Zwischen dem Drainanschluß D und der ersten Klemme 1 liegt eine Primärwicklung 57 eines Übertragers 56 des Schaltnetzteiles. Der Sourceanschluß S des MOS-FET 55 ist mit der auf Masse liegenden zweiten Klemme 2 elektrisch verbunden. Ausgangsseitig weist der Übertrager 56 zwei Sekundärwicklungen 58, 59 auf, wobei die zweite Sekundärwicklung 59 als Hilfswicklung zum Bereitstellen einer Versorgungsspannung für die Steuereinrichtung 54 dient. Die erste Sekundärwicklung 58 ist über eine Gleichrichteranordnung, hier eine Diode 61, mit nachgeschaltetem Querkondensator 63 verbunden. An Ausgangsklemmen 64, 65 dieses ersten Sekundärkreises des Schaltnetzteiles ist ein gleichgerichtetes Spannungssignal, das beispielsweise zur Versorgung eines Fernsehgerätes dient, abgreifbar. Die zweite Sekundärwicklung 59 ist ebenfalls mit einer Gleichrichteranordnung versehen. Dort ist der Anodenanschluß einer Diode 62 mit dem ersten Anschluß der Sekundärwicklung 59 in Verbindung. Der Kathodenanschluß ist mit der dritten Klemme 3 der Anlaufschaltung 53 und damit mit der Speisespannungsklemme der Steuereinrichtung 54 in Kontakt. Zwischen die zweite Klemme 2 und die dritte Klemme 3 ist ein Kondensator 60 und ein Widerstand 66 geschaltet.

Unmittelbar nachdem die Klemmen 50, 51 an eine Netzwechselspannung gelegt werden, beginnt die Anlaufschaltung 53 die Steuereinrichtung 54 mit Spannung zu versorgen. An den Ausgängen der beiden Sekundärkreise des Übertragers 56 ist noch keine Spannung abgreifbar, da sich die Eingangsspannung an der Steuereinrichtung 54 erst aufbauen muß, um den MOS-FET 55 steuern zu können. Nachdem sich diese Spannung innerhalb der Steuereinrichtung 54 aufgebaut hat, beginnt der MOS-FET 55 ein- und auszuschalten, so daß sowohl im ersten Sekundärkreis als auch im zweiten Sekundärkreis eine Spannung abgegriffen werden kann. Die im zweiten Sekundärkreis gebildete Spannung wird, wie in Figur 3 dargestellt, auf die Speisespannungsklemme der Steuereinrichtung 54 und damit die dritte Klemme 3 zurückgekoppelt, so daß nach einem erfolgten Anlaufen der Steuereinrichtung 54 die Spannungsversorgung ausschließlich durch den zweiten Sekundärkreis des Schaltnetztteiles erfolgen kann. Da voraussetzungsgemäß in diesem Fall die vom zweiten Sekundärkreis bereitgestellte Versorgungsspannung größer als die Zenerspannung in der Anlaufschaltung 53 ist, wird die Anlaufschaltung 53 ausgeschaltet, d. h. die leitende Verbindung zwischen der ersten Klemme 1 und der dritten Klemme 3 geöffnet.

## Patentansprüche

1. Anlaufschaltung für eine Schaltungsanordnung mit drei Klemmen (1, 2, 3), von denen eine erste Klemme (1) und eine zweite Klemme (2) mit zwei Anschlüssen einer Eingangsspannung und die zweite Klemme (2) und die dritte Klemme (3) mit der Schaltungsanordnung verbindbar sind, **gekennzeichnet** durch die Merkmale :
a) Zwischen die erste Klemme (1) und die dritte Klemme (3) ist ein Depletion-MOS-FET (4) mit seiner Laststrecke geschaltet,
b) zwischen die zweite Klemme (2) und einen Gateanschluß (G) des Depletion-MOS-FET (4) ist eine Zenerdiode (5) geschaltet,
c) zwischen die dritte Klemme (3) und den Gateanschluß (G) des Depletion-MOS-FET (4) ist ein Widerstand (6) geschaltet.

2. Anlaufschaltung nach Anspruch 1,
**dadurch gekennzeichnet**, daß der Widerstand (6) ein MOS-FET ist, dessen Gateanschluß (G) und Sourceanschluß (S) mit dem Gateanschluß (G) des Depletion-MOS-FET (4) und dessen Drainanschluß (D) mit der dritten Klemme (3) verbunden ist.

3. Anlaufschaltung nach Anspruch 2,
**dadurch gekennzeichnet**, daß der MOS-FET (6) ein n-Kanal-Enhancement-MOS-FET ist, mit einer Einsatzspannung von etwa 3 - 10 Volt.

4. Anlaufschaltung nach einem der Ansprüche 1 bis 3,
**dadurch gekennzeichnet**, daß die Zenerdiode (5) eine Zenerspannung von etwa 6 - 10 Volt aufweist.

5. Anlaufschaltung nach einem der Ansprüche 1 bis 4,
**dadurch gekennzeichnet**, daß der Depletion-MOS-FET (4) eine Durchbruchsspannung von etwa 800 - 1000 Volt aufweist.

6. Halbleiterkörper für eine Anlaufschaltung nach einem der Ansprüche 1 bis 5, gekennzeichnet durch einen n⁻-dotierten Grundkörper (20), an dessen unteren Hauptfläche eine n⁺-dotierte Zone (21) anschließt und an dessen oberen Hauptfläche in einem ersten Bereich (B1) n⁺-dotierte Wannen (24) enthaltende p-dotierte Zonen (23) zur Bildung eines vertikalen Depletion-MOS-FET, in einem zweiten Bereich (B2) ein lateraler Widerstand und in einem dritten Bereich (B3) eine eine n⁺-dotierte Wanne (33) enthaltende p-dotierte Zone (32) zur Bildung einer Zenerdiode eingebettet sind.

7. Halbleiterkörper nach Anspruch 6,
**dadurch gekennzeichnet**, daß der laterale Widerstand im zweiten Bereich (B2) als MOS-FET ausgebildet ist, indem in die obere Hauptfläche des n⁻-dotierten Grundkörpers 20 eine mindestens zwei n⁺-dotierte Wannen (28, 29) enthaltende p-dotierte Zone (27) eingebettet ist.

8. Halbleiterkörper nach Anspruch 6 oder 7,
**dadurch gekennzeichnet**, daß die n⁺-dotierte Zone (21) von der ersten Klemme (1) des Halbleiterkörpers kontaktiert ist, daß die p-dotierte Zone (32) im dritten Bereich (B3) von der zweiten Klemme (2) des Halbleiterkörpers kontaktiert ist, daß die dritte Klemme (3), sowohl einen Anschluß des lateralen Widerstandes als auch mindestens eine n⁺-dotierte Wanne (24) im ersten Bereich (B1) kontaktiert, und daß die n⁺-dotierte Wanne (33) im dritten Bereich (B3) mit einer Gateelektrode (G) im ersten Bereich (B1) und dem anderen Anschluß des lateralen Widerstandes im zweiten Bereich (B2) des Halbleiterkörpers elektrisch leitend verbunden ist.
